# EUROPEAN PATENT SPECIFICATION

(11) **EP 4 378 077 B1**
(45) Date of publication and mention of the grant of the patent: **09.12.2026**
(21) Application number: 22758078.4
(22) Date of filing: 01.08.2022
(51) Int. Cl.: H03H 9/05, H01F 17/00

(54) **BULK ACOUSTIC WAVE RESONATOR WITH AN INTEGRATED PASSIVE DEVICE FABRICATED USING BUMP PROCESS**
VOLUMENSCHALLWELLENRESONATOR MIT EINER INTEGRIERTEN PASSIVEN VORRICHTUNG, DIE MITTELS BUMP-VERFAHREN HERGESTELLT WIRD
RÉSONATEUR À ONDES ACOUSTIQUES DE VOLUME MUNI D'UN DISPOSITIF PASSIF INTÉGRÉ FABRIQUÉ À L'AIDE D'UN PROCÉDÉ PAR BOSSAGE

(30) Priority: 30.07.2021 US 202117389619
(43) Date of publication of application: 05.06.2024
(73) Proprietor: Texas Instruments Incorporated, Dallas, TX 75265 (US)
(72) Inventor: YEN, Ting-Ta, San Jose, CA 95110 (US); YU, Yao, San Jose, CA 95133 (US); ALI, Hassan, Omar, Murphy, TX 75094 (US)
(74) Representative: Zeller, Andreas
(86) International application number: PCT/US2022/038995
(87) International publication number: WO 2023/009884

(56) References cited:
- WO-A1-2019/132937
- US-A- 5 411 135
- US-A- 5 541 135
- US-A1- 2002 160 576
- US-A1- 2005 167 780
- US-A1- 2018 048 291

## Description

### BACKGROUND

Passive devices, such as inductors, capacitors, and resistors, are commonly used in electronic circuits. Like transistors, passive devices may be fabricated by patterning the various layers (e.g., metal, insulator, etc.) of an integrated circuit. For example, an inductor may be fabricated by etching a metal layer to create a desired inductor pattern. Similarly, a capacitor may be fabricated by etching a metal layer to create the top and bottom plates of the capacitor. The Document WO 2019/132937 A1 discloses hybrid filters having acoustic wave resonators and lumped component resonators and packages therefore. Further, Document US 2018/048291 A1 discloses a bulk-acoustic wave filter device. Moreover, Document US 2005/167780 A1 discloses an inductor and a method of forming the inductor. Furthermore, Document US 2002/160576 A1 relates to a monolithic integrated circuit incorporating an inductive component. In addition, Document US 5 541 135 A discloses a method of fabricating a flip chip semiconductor device having an inductor.

### SUMMARY

The invention is defined by the features of the appended claims. In one example, a circuit includes a semiconductor substrate and an integrated passive device. The integrated passive device is on a surface of the semiconductor substrate. The integrated passive device is in a metal layer on the semiconductor substrate. The metal layer is at least tens of micrometers thick.

In another example, a resonator circuit includes a semiconductor substrate. A bulk acoustic wave resonator is on the semiconductor substrate. A metal layer that is at least tens of micrometers thick is also on a surface of the semiconductor substrate. The metal layer is patterned to form an inductor coupled to the bulk acoustic wave resonator.

In a further example, a radio frequency (RF) circuit includes a semiconductor substrate. A metal layer is on a surface of the semiconductor substrate. The metal layer is at least 30 micrometers thick. The metal layer is patterned to form a first I/O terminal, a second I/O terminal, and an inductor. The inductor includes a terminal coupled to the first I/O terminal.

### BRIEF DESCRIPTION OF THE DRAWINGS

FIG. 1A is a schematic diagram for a resonator circuit using a bulk acoustic wave (BAW) resonator in series with a high-quality factor (Q) inductor.
FIG. 1B shows a die that includes a BAW resonator, a high-Q inductor, and I/O terminals configured as in FIG. 1.
FIG. 1C is a graph of frequency versus amplitude for the resonator circuit of FIG. 1.
FIG. 2A is a schematic diagram for a resonator circuit using a BAW resonator in parallel with a high-Q inductor.
FIG. 2B shows a die that includes a BAW resonator, a high-Q inductor, and I/O terminals configured as in FIG. 4.
FIG. 2C is a graph of frequency versus amplitude for the resonator circuit of FIG. 4.
FIG. 3A is a schematic diagram for a filter circuit that includes a BAW resonator in parallel with a high-Q inductor.
FIG. 3B is a graph of bandwidth for the filter circuit of FIG. 3A.
FIG. 4A is a schematic diagram for a filter circuit that includes a BAW resonator in series with a high-Q inductor.
FIG. 4B is a graph of bandwidth for the filter circuit of FIG. 4A.
FIG. 5A is a schematic diagram for a filter circuit that includes a BAW resonator in series with a high-Q inductor.
FIG. 5B is a graph of bandwidth for the filter circuit of FIG. 5A.
FIG. 6A is a schematic diagram for a filter circuit that includes a BAW resonator in parallel with a high-Q inductor.
FIG. 6B is a graph of bandwidth for the filter circuit of FIG. 6A.
FIG. 7 is a schematic diagram for a radio frequency circuit that includes an integrated passive device.
FIG. 8 shows a die having a BAW resonator, an inductor, I/O terminals, and solder seal.
FIG. 9 shows a cross-sectional view of the die of FIG. 8 aligned for attachment to a base die.

### DETAILED DESCRIPTION OF EXAMPLE EMBODIMENTS

Passive components fabricated using complementary metal oxide semiconductor (CMOS) or micro-electro-mechanical system (MEMS) metal may be limited by the thickness of the metal layers. For example, a metal layer in a MEMS or CMOS process may be 1-2 micrometers (µm) thick. Inductors fabricated using such relatively thin metal have a poor quality factor (Q), $Q = \frac{ωL}{R} ,$ where:
*R* is the DC resistance of the inductor;
*L* is the inductance of the inductor; and
*ωL* is inductive reactance.

Inductors and capacitors are used in a variety of circuits. For example, inductors may be used in bulk acoustic wave (BAW) resonator circuits and matching networks may be used to couple radio frequency (RF) components. Conventional circuits may use the low-Q inductors fabricated using MEMS or CMOS metal processes, or use inductors and capacitors external to the integrated circuit. A BAW resonator's tuning range and filter bandwidth are limited by the effective coupling (*K_{eff}²*) of constituent BAW resonators. A low *K_{eff}²* (caused by a low-Q inductor) results in a small resonator tuning range and limited filter bandwidth that, in turn, increases yield loss. Use of external inductors and capacitors increases circuit area and cost. For example, use of external inductors in RF matching networks and antennas in an RF system increases the circuit area and cost of the RF system.

The circuits described herein employ passive components (e.g., inductors and capacitors) fabricated as part of the integrated circuit packaging process. The metal electroplated or deposited during the packaging process is much thicker than the metal layers formed in CMOS or MEMS processing. For example, a metal layer electroplated in the packaging process may be 30-100 µm thick, while a metal layer formed in CMOS or MEMS processing may be only 1-2 µm thick. Inductors fabricated using the thicker metal layer may have a high-Q (e.g., 30-50) and be suitable for use in a variety of applications, including BAW resonators and filters, RF matching networks, and antenna miniaturization.

In the circuits described herein, integrated passive components may be created using a bump process that is also used to form I/O terminals (e.g., copper posts of a flip-chip package) on a wafer prior to singulation. In addition to passive components and I/O terminals, the bump process may be used to create a solder seal structure (a seal ring) about circuit or MEMS components. The seal ring isolates and protects the circuit or the MEMS components disposed within the seal ring from packaging materials, such as mold compound.

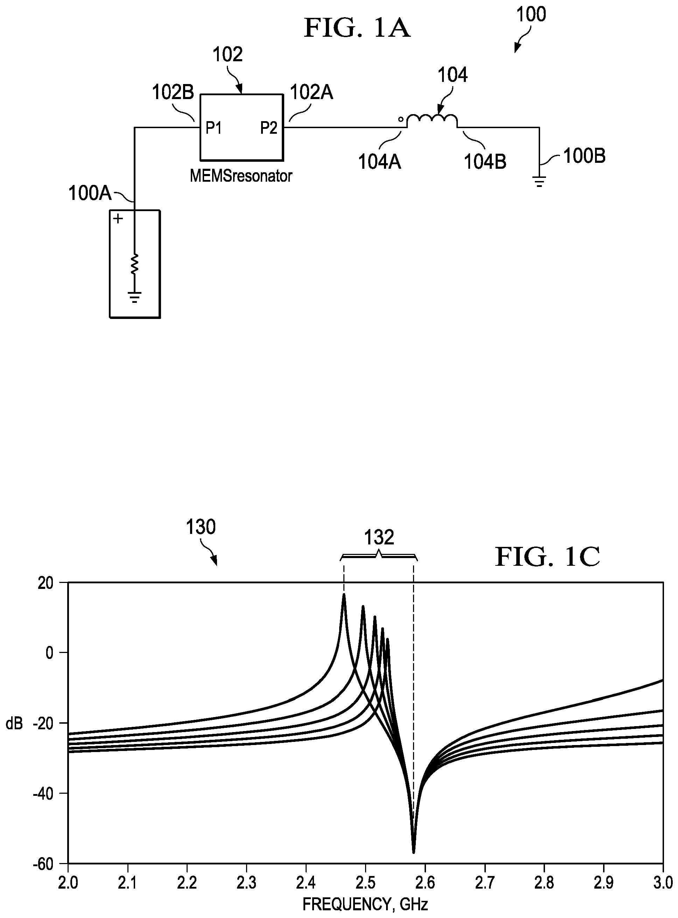

FIG. 1A is a schematic diagram for a resonator circuit 100 using a bulk acoustic wave (BAW) resonator 102 in series with a high-Q inductor 104. The BAW resonator 102 is a piezoelectric resonator. The inductor 104 is fabricated using a bump process. The metal layer deposited to form the inductor 104 may be 30-100 micrometers thick. The inductor 104 may have Q factor in a range of about 30-50 in some implementations. The resonator circuit 100 includes I/O terminals 100A and 100B that are fabricated using the bump process. The inductor 104 includes a terminal 104A coupled to a terminal 102A of the BAW resonator 102, and a terminal 104B coupled to an I/O terminal 100A. A terminal 102B of the BAW resonator 102 is coupled to the I/O terminal 100B of the resonator circuit 100.

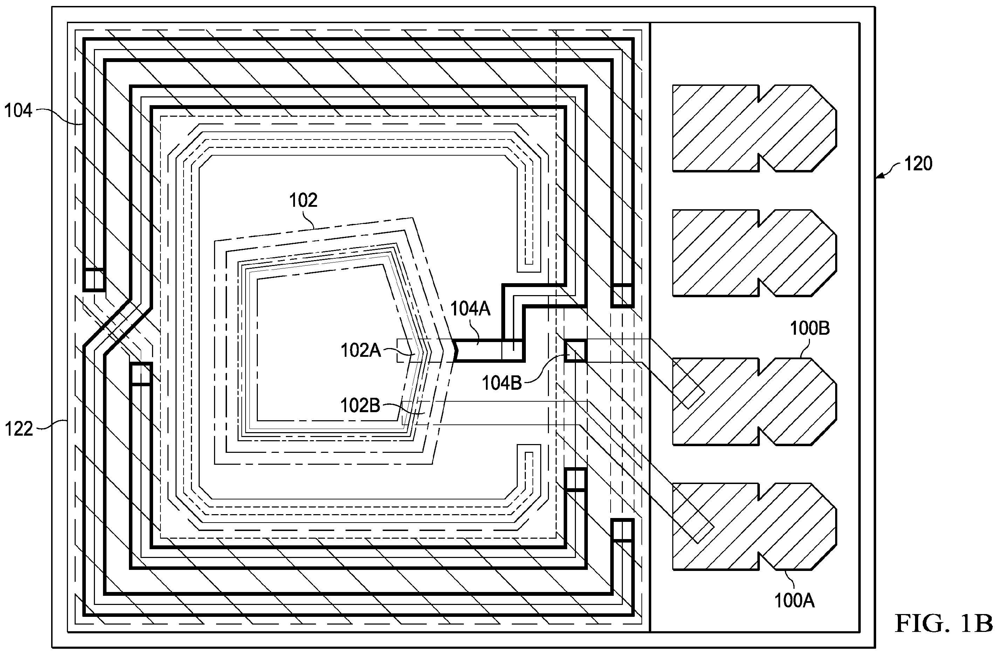

FIG. 1B shows a die 120 that includes the BAW resonator 102, the inductor 104, and the I/O terminals 100A and 100B of FIG. 1. The die 120 includes a semiconductor substrate 122 (e.g., a silicon substrate). The BAW resonator 102, the inductor 104, the 100A and the 100B are formed on the semiconductor substrate 122.

FIG. 1C is a graph 130 of frequency versus amplitude for the resonator circuit of FIG. 1. The graph 130 shows the inductor 104 enables a wide tuning range 132 in the resonator circuit 100. The wide tuning range 132 reduces yield loss and cost.

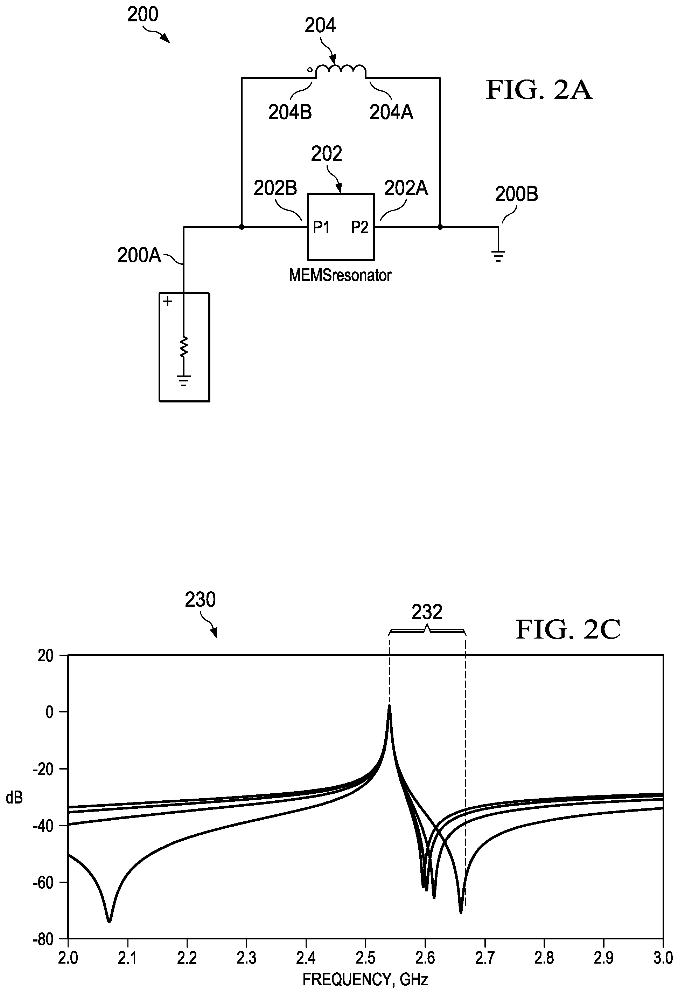

FIG. 2A is a schematic diagram for a resonator circuit 200 using a bulk acoustic wave (BAW) resonator 202 in parallel with a high Q inductor 204. The inductor 204 is fabricated using a bump process. The metal layer deposited to form the inductor 204 may be 30-100 micrometers thick. The inductor 204 may have Q factor in a range of about 30-50 in some implementations. The resonator circuit 200 includes I/O terminals 200A and 200B that are fabricated using the bump process. The inductor 204 includes a terminal 204A coupled to a terminal 202A of the BAW resonator 202, and a terminal 204B coupled to the terminal 202B of the BAW resonator 202. The terminal 202A is coupled to an I/O terminal 200B of the resonator circuit 200. A terminal 202B of the BAW resonator 202 is coupled to an I/O terminal 200A of the resonator circuit 200.

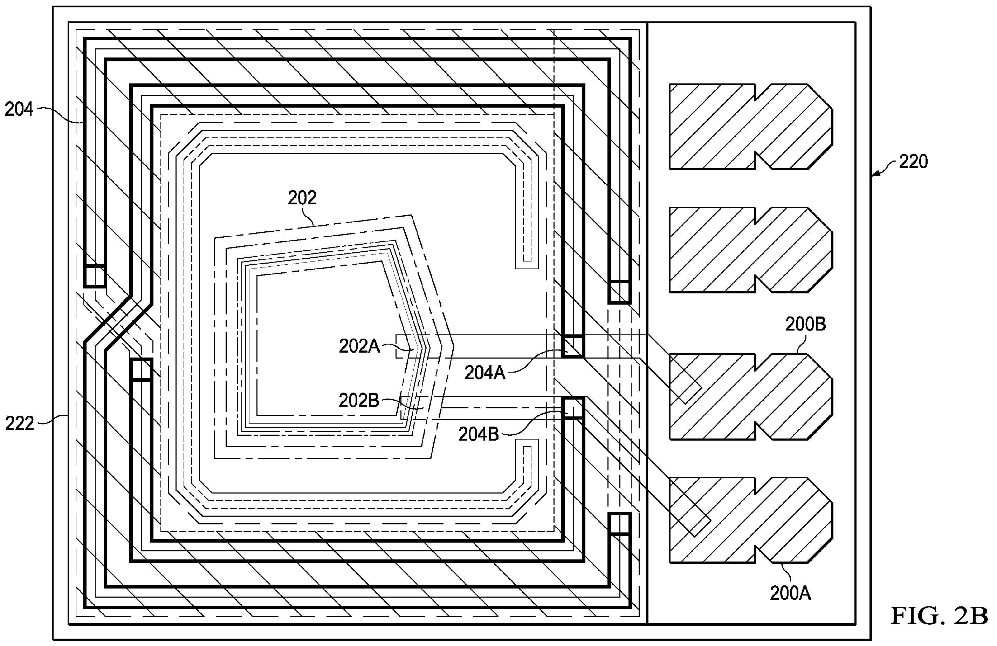

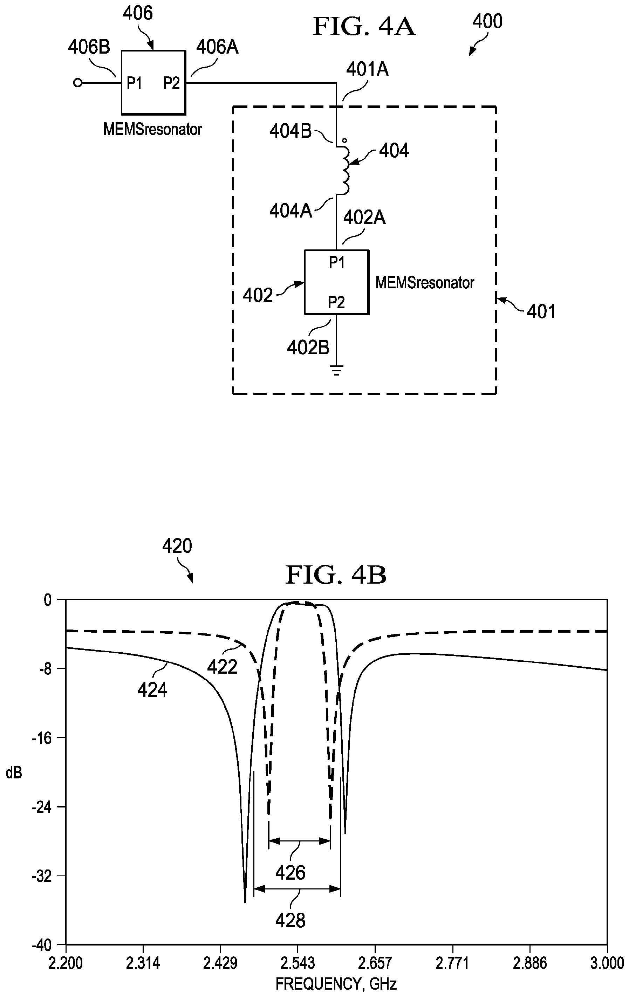

FIG. 2B shows a die 220 that includes the BAW resonator 202, the inductor 204, and the I/O terminals 200A and 200B of FIG. 4. The die 220 includes a semiconductor substrate 222. The BAW resonator 202, the inductor 204, the 200A and the 200B are formed on the semiconductor substrate 222.

FIG. 2C is a graph 230 of frequency versus amplitude for the resonator circuit of FIG. 4. The graph 230 shows that the inductor 204 enables a wide tuning range 232 in the resonator circuit 200. The wide tuning range 232 reduces yield loss and cost.

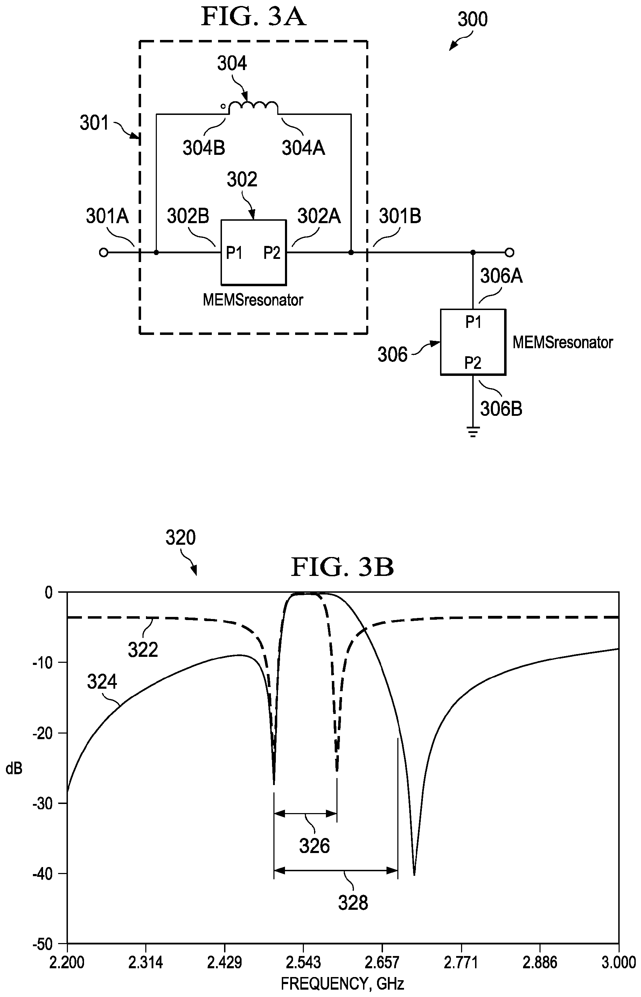

FIG. 3A is a schematic diagram for a filter circuit 300 that includes a BAW resonator 302 in parallel with a high-Q inductor 304 (both are in a series branch), and a BAW resonator 306 in a parallel branch. The BAW resonator 302 and the inductor 304 may be disposed on a same die 301, as shown in FIG. 2B. The filter circuit 300 also includes a second BAW resonator 306. The BAW resonator 306 may be disposed on the die 301, or disposed on a different die. The inductor 304 is fabricated using a bump process. The metal layer deposited to form the inductor 304 may be 30-100 micrometers thick. The inductor 304 may have Q factor in a range of about 30-50 in some implementations. The die 301 includes I/O terminals 301A and 301B that are fabricated using the bump process. The inductor 304 includes terminals 304A and 304B respectively coupled to terminals 302A and 302B of the BAW resonator 302. The terminal 302A is coupled to an I/O terminal 301B of the die 301. A terminal 302B of the BAW resonator 302 is coupled to an I/O terminal 301A of the die 301. The BAW resonator 306 includes a terminal 306A coupled to the I/O terminal 301B. A terminal 306B of the BAW resonator 306 is coupled to ground.

FIG. 3B is a graph 320 of bandwidth for the filter circuit 300. The bandwidth of the filter circuit 300 is illustrated as curve 324, and the bandwidth of a BAW resonator filter using a lower Q inductor is illustrated as curve 322. As shown by the curves 322 and 324, the bandwidth of the filter circuit 300 (using the high Q inductor formed on the die 301) substantially exceeds the bandwidth of the filter using the lower Q inductor.

FIG. 4A is a schematic diagram for a filter circuit 400 that includes a BAW resonator 402 in series with a high Q inductor 404 (both are in a parallel branch), and a BAW resonator 406 in a series branch. The BAW resonator 402 and the inductor 404 may be disposed on a same die 401, as shown in FIG. 1B. The filter circuit 400 also includes a second BAW resonator 406. The BAW resonator 406 may be disposed on the die 401, or disposed on a different die. The inductor 404 is fabricated using a bump process. The metal layer deposited to form the inductor 404 may be 30-100 micrometers thick. The inductor 404 may have Q factor in a range of about 30-50 in some implementations. The die 401 includes an I/O terminal 401A that is fabricated using the bump process. The inductor 404 includes terminals 404A and 404B respectively coupled to terminal 402A of the BAW resonator 402 and I/O terminal 401A of the die 401. The BAW resonator 406 includes a terminal 406A coupled to the 301A and a terminal 406B.

FIG. 4B is a graph 420 of bandwidth for the filter circuit 400. The bandwidth of the filter circuit 400 is illustrated as curve 424, and the bandwidth of a BAW resonator filter using a lower Q inductor is illustrated as curve 422. As shown by the curves 422 and 424, the bandwidth of the filter circuit 400 (using the high-Q inductor formed on the die 401) substantially exceeds the bandwidth of the filter using the lower Q inductor.

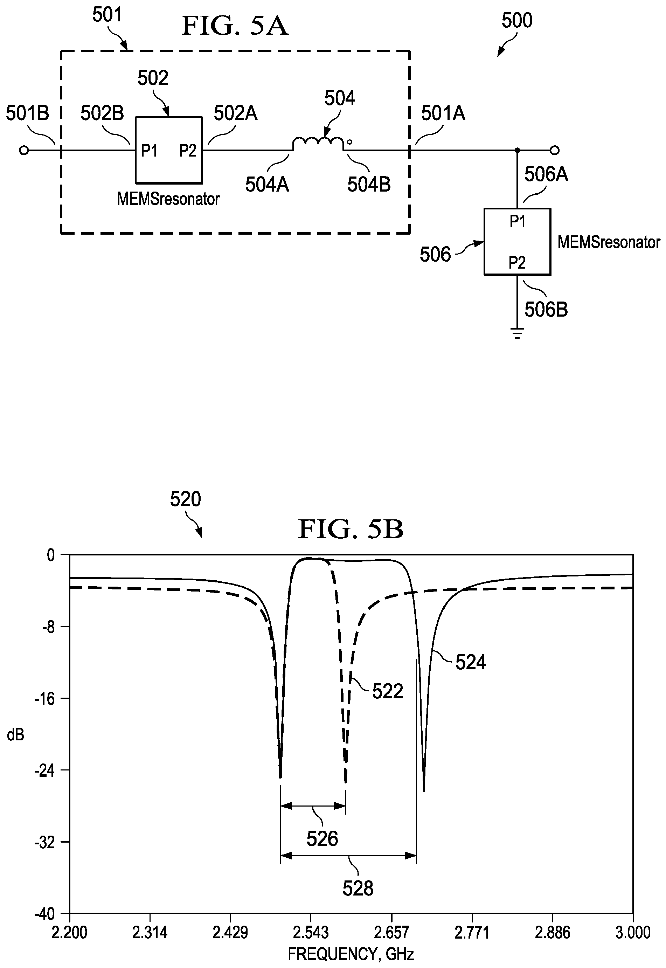

FIG. 5A is a schematic diagram for a filter circuit 500 that includes a BAW resonator 502 in series with a high-Q inductor 504 (both are in a series branch), and a BAW resonator 506 in a parallel branch. The BAW resonator 502 and the inductor 504 may be disposed on a same die 501, as shown in FIG. 1B. The filter circuit 500 also includes a second BAW resonator 506. The BAW resonator 506 may be disposed on the die 501, or disposed on a different die. The inductor 504 is fabricated using a bump process. The metal layer deposited to form the inductor 504 may be 30-100 micrometers thick. The inductor 504 may have Q factor in a range of about 30-50 in some implementations. The die 501 includes I/O terminals 501A and 501B that are fabricated using the bump process. The inductor 504 includes terminals 504A and 504B respectively coupled to terminal 502A of the BAW resonator 502 and terminal 501A of the die 501. The I/O terminal 501B is coupled to a terminal 502B of the BAW resonator 502. The BAW resonator 506 includes a terminal 506A coupled to the I/O terminal 501A and a terminal 506B coupled to ground.

FIG. 5B is a graph 520 of bandwidth for the filter circuit 500. The bandwidth of the filter circuit 500 is illustrated as curve 524, and the bandwidth of a BAW resonator filter using a lower Q inductor is illustrated as curve 522. As shown by the curves 522 and 524, the bandwidth of the filter circuit 500 (using the high Q inductor formed on the die 501) substantially exceeds the bandwidth of the filter using the lower Q inductor.

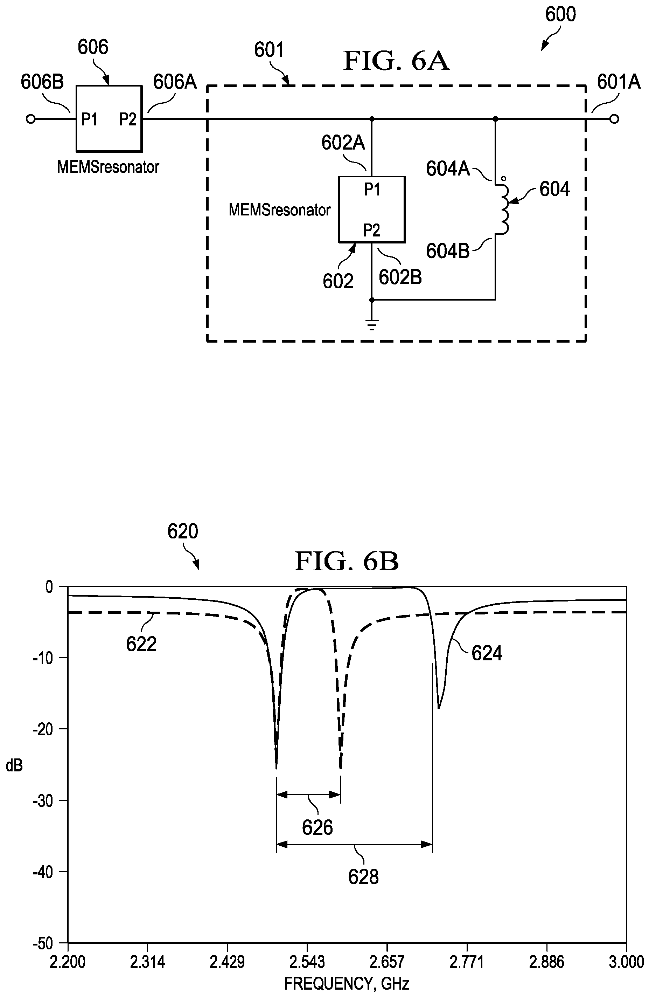

FIG. 6A is a schematic diagram for a filter circuit 600 that includes a BAW resonator 602 in parallel with a high-Q inductor 604 (both are in a parallel branch), and a BAW resonator 606 in a series branch. The BAW resonator 602 and the inductor 604 may be disposed on a same die 601, as shown in FIG. 1B. The filter circuit 600 also includes a second BAW resonator 606. The BAW resonator 606 may be disposed on the die 601, or disposed on a different die. The inductor 604 is fabricated using a bump process. The metal layer deposited to form the inductor 604 may be 30-100 micrometers thick. The inductor 604 may have Q factor in a range of about 30-50 in some implementations. The die 601 includes an I/O terminal 601A that is fabricated using the bump process. The inductor 604 includes terminals 604A and 604B respectively coupled to terminals 602A and 602B of the BAW resonator 602, terminal 606A of the BAW resonator 606, and I/O terminal 601A of the die 601. Terminal 604B of the inductor 604 is coupled to ground.

FIG. 6B is a graph 620 of bandwidth for the filter circuit 600. The bandwidth of the filter circuit 600 is illustrated as curve 624, and the bandwidth of a BAW resonator filter using a lower Q inductor is illustrated as curve 622. As shown by the curves 622 and 624, the bandwidth of the filter circuit 600 (using the high Q inductor formed on the die 601) substantially exceeds the bandwidth of the filter using the lower Q inductor.

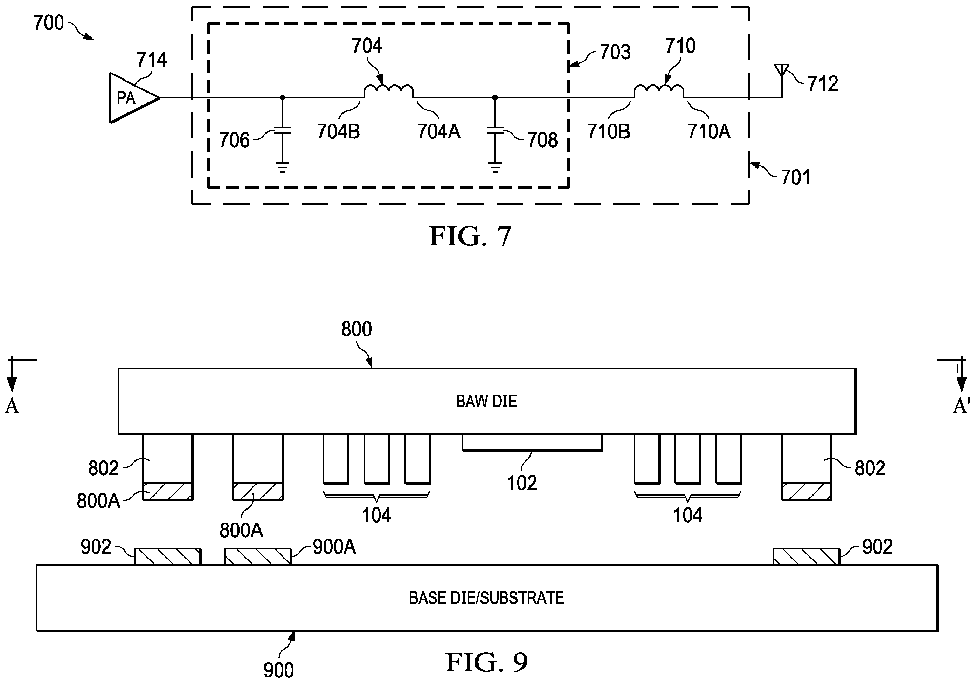

FIG. 7 is a schematic diagram for a radio frequency circuit 700 that includes an integrated passive device as described herein. The radio frequency circuit 700 includes a power amplifier 714, an antenna 712, a matching network 703, and an inductor 710. The matching network 703 matches the impedances of the power amplifier 714 and antenna 712. The inductor 710 increases the length of the antenna 712 to allow for reduction in size of the antenna 712.

The matching network 703 and the inductor 710 may be formed on a die 701. The matching network 703 includes an inductor 704, a capacitor 706, and a capacitor 708. The inductors 704 and 710, and the capacitors 706 and 708 are fabricated using a bump process. The metal layer deposited to form the inductors 704 and 710, and the capacitors 706 and 708 may be 30-100 micrometers thick. The capacitors 706 and 708 may be patterned as interdigital capacitors. The inductors 704 and 710 may have a Q factor in a range of about 30-50 in some implementations.

A terminal 704B of the inductor 704 is coupled to the capacitor 706 and an output of the power amplifier 714. A terminal 704A of the inductor 704 is coupled to the capacitor 708 and terminal 710B of the inductor 710. Terminal 710A of the inductor 710 is coupled to the antenna 712. By disposing the matching network 703 and the inductor 710 on the die 701, the size and cost of the radio frequency circuit 700 may be reduced. In various implementations of the radio frequency circuit 700, the matching network 703 and/or the inductor 710 may be disposed on the die 701.

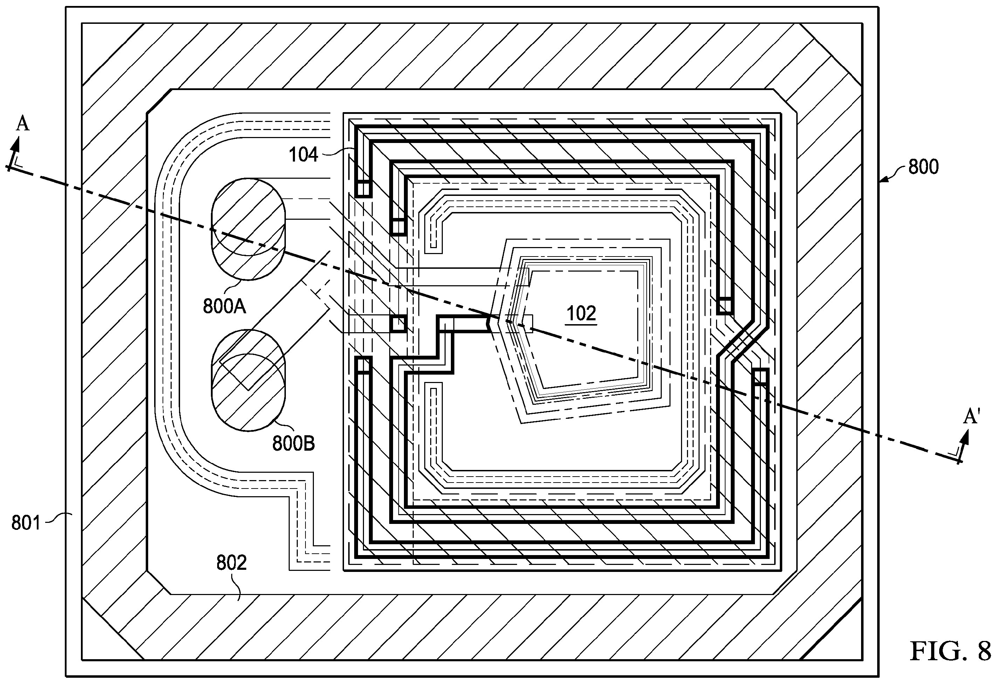

FIG. 8 shows a die 800. The die 800 includes a substrate 801. The BAW resonator 102, the inductor 104, I/O terminals 800A and 800B, and the seal ring 802 are formed on the substrate 801. The inductor 104, the I/O terminal 800A, the I/O terminal 800B, and the seal ring 802 are formed using a bump process to pattern a relatively thick metal layer. The seal ring 802 encircles the BAW resonator 102, the inductor 104, the I/O terminal 800A and the I/O terminal 800B.

FIG. 9 shows a cross-sectional view of the die 800 and a base die 900. The die 900 includes a seal ring 902 and an I/O terminal 900A. The I/O terminal 900A is attached to the I/O terminal 800A by solder reflow to allow transfer of signal between the die 800 and the base die 900. The seal ring 902 is attached to the seal ring 802 by solder reflow to seal the BAW resonator 102, the inductor 104, and the I/O terminal 800A within the seal ring 802 and between the die 800 and the base die 900.

In this description, the term "couple" or "couples" may cover connections, communications, or signal paths that enable a functional relationship consistent with this description. For example, if device A generates a signal to control device B to perform an action: (a) in a first example, device A is coupled to device B; or (b) in a second example, device A is coupled to device B through intervening component C if intervening component C does not substantially alter the functional relationship between device A and device B, such that device B is controlled by device A via the control signal generated by device A. Also, in this description, the recitation "based on" means "based at least in part on." Therefore, if X is based on Y, then X may be a function of Y and any number of other factors.

Modifications are possible in the described embodiments, and other embodiments are possible, within the scope of the claims.

## Claims

1. A circuit, comprising:
a semiconductor substrate (800); and
an integrated passive device (104) on a surface of the semiconductor substrate (800), the integrated passive device (104) in a metal layer (802) that is at least 30 micrometers thick on the semiconductor substrate (800), wherein the integrated passive device (104) is an inductor, the circuit further comprising:
a bulk acoustic wave resonator (102) on the semiconductor substrate (800), coupled to the inductor (104),
a first I/O terminal (800A) in the metal layer (802);
a second I/O terminal (800B) in the metal layer (802); and
a capacitor in the metal layer (802), wherein the inductor (104) includes:
a first terminal coupled to the first I/O terminal (800A); and
a second terminal coupled to the second I/O terminal (800B) and a terminal of the capacitor.

2. The circuit of claim 1, further comprising a seal ring in the metal layer (802); wherein the bulk acoustic wave resonator (102) and the inductor (104) are within the seal ring.

3. The circuit of claim 1, wherein the bulk acoustic wave resonator (102) is coupled in series with the inductor (104).

4. The circuit of claim 3, further comprising:
the first I/O terminal (800A) in the metal layer (802); and
the second I/O terminal (800B) in the metal layer (802);
wherein:
the inductor (104) includes:
a first terminal coupled to the first I/O terminal (800A); and
a second terminal;
the bulk acoustic wave resonator (102) includes:
a first terminal coupled to the second terminal of the inductor (104); and
a second terminal coupled to the second I/O terminal (800B).

5. The circuit of claim 1, wherein the bulk acoustic wave resonator (102) is coupled in parallel with the inductor (104).

6. The circuit of claim 5, further comprising:
the first I/O terminal (800A) in the metal layer (802); and
the second I/O terminal (800B) in the metal layer (802);
wherein:
the inductor (104) includes:
a first terminal coupled to the first I/O terminal (800A); and
a second terminal coupled to the second I/O terminal (800B).

7. The circuit of claim 1, wherein:
the inductor (104) is a first inductor; and
the circuit includes:
a second inductor in the metal layer (802); and
the second inductor includes:
a first terminal coupled to the first terminal of the first inductor (104); and
a second terminal coupled to the second I/O terminal (800B).

8. The circuit of claim 1, comprising:
a bulk acoustic wave resonator (102) on the semiconductor substrate (800); and
the metal layer (802) that is at least 30 micrometers thick on a surface of the semiconductor substrate (800); the metal layer (802) patterned to form the inductor (104) coupled to the bulk acoustic wave resonator (102).

9. The circuit of claim 8, further comprising a seal ring in the metal layer (802); wherein the bulk acoustic wave resonator (102) and the inductor (104) are within the seal ring.

10. The circuit of claim 8, wherein the bulk acoustic wave resonator (102) is coupled in series with the inductor (104).

11. The circuit of claim 10, further comprising:
the first I/O terminal (800A) in the metal layer (802); and
the second I/O terminal (800B) in the metal layer (802);
wherein:
the inductor (104) includes:
a first terminal coupled to the first I/O terminal (800A); and
a second terminal;
the bulk acoustic wave resonator (102) includes:
a first terminal coupled to the second terminal of the inductor (104); and
a second terminal coupled to the second I/O terminal (800B).

12. The circuit of claim 8, wherein the bulk acoustic wave resonator (102) is coupled in parallel with the inductor (104).

13. The circuit of claim 12, further comprising:
the first I/O terminal (800A) in the metal layer (802); and
the second I/O terminal (800B) in the metal layer (802);
wherein:
the inductor (102) includes:
a first terminal coupled to the first I/O terminal (800A); and
a second terminal coupled to the second I/O terminal (800B).

## Patentansprüche

1. Schaltung, umfassend:
ein Halbleitersubstrat (800); und
eine integrierte passive Vorrichtung (104) auf einer Oberfläche des Halbleitersubstrats (800), wobei sich die integrierte passive Vorrichtung (104) in einer Metallschicht (802), die mindestens 30 Mikrometer dick ist, auf dem Halbleitersubstrat (800) befindet, wobei die integrierte passive Vorrichtung (104) eine Induktivität ist, wobei die Schaltung ferner umfasst:
einen Volumenschallwellenresonator (102) auf dem Halbleitersubstrat (800), der mit der Induktivität (104) gekoppelt ist,
einen ersten E/A-Anschluss (800A) in der Metallschicht (802);
einen zweiten E/A-Anschluss (800B) in der Metallschicht (802); und
einen Kondensator in der Metallschicht (802), wobei die Induktivität (104) beinhaltet:
einen ersten Anschluss, der mit dem ersten E/A-Anschluss (800A) gekoppelt ist; und
einen zweiten Anschluss, der mit dem zweiten E/A-Anschluss (800B) und einem Anschluss des Kondensators gekoppelt ist.

2. Schaltung nach Anspruch 1, die ferner einen Dichtungsring in der Metallschicht (802) umfasst; wobei sich der Volumenschallwellenresonator (102) und die Induktivität (104) innerhalb des Dichtungsrings befinden.

3. Schaltung nach Anspruch 1, wobei der Volumenschallwellenresonator (102) mit der Induktivität (104) in Reihe gekoppelt ist.

4. Schaltung nach Anspruch 3, die ferner umfasst:
den ersten E/A-Anschluss (800A) in der Metallschicht (802); und
den zweiten E/A-Anschluss (800B) in der Metallschicht (802);
wobei:
die Induktivität (104) beinhaltet:
einen ersten Anschluss, der mit dem ersten E/A-Anschluss (800A) gekoppelt ist; und
einen zweiten Anschluss;
wobei der Volumenschallwellenresonator (102) beinhaltet:
einen ersten Anschluss, der mit einem zweiten Anschluss der Induktivität (104) gekoppelt ist; und
einen zweiten Anschluss, der mit dem zweiten E/A-Anschluss (800B) gekoppelt ist.

5. Schaltung nach Anspruch 1, wobei der Volumenschallwellenresonator (102) mit der Induktivität (104) parallel gekoppelt ist.

6. Schaltung nach Anspruch 5, die ferner umfasst:
den ersten E/A-Anschluss (800A) in der Metallschicht (802); und
den zweiten E/A-Anschluss (800B) in der Metallschicht (802);
wobei:
die Induktivität (104) beinhaltet:
einen ersten Anschluss, der mit dem ersten E/A-Anschluss (800A) gekoppelt ist; und
einen zweiten Anschluss, der mit dem zweiten E/A-Anschluss (800B) gekoppelt ist.

7. Schaltung nach Anspruch 1, wobei:
die Induktivität (104) eine erste Induktivität ist; und
die Schaltung beinhaltet:
eine zweite Induktivität in der Metallschicht (802); und
wobei die zweite Induktivität beinhaltet:
einen ersten Anschluss, der mit dem ersten Anschluss der ersten Induktivität (104) gekoppelt ist; und
einen zweiten Anschluss, der mit dem zweiten E/A-Anschluss (800B) gekoppelt ist.

8. Schaltung nach Anspruch 1, die umfasst:
einen Volumenschallwellenresonator (102) auf dem Halbleitersubstrat (800); und
die Metallschicht (802), die mindestens 30 Mikrometer dick ist, auf einer Oberfläche des Halbleitersubstrats (800); wobei die Metallschicht (802) strukturiert ist, um die Induktivität (104) zu bilden, die mit dem Volumenschallwellenresonator (102) gekoppelt ist.

9. Schaltung nach Anspruch 8, die ferner einen Dichtungsring in der Metallschicht (802) umfasst; wobei sich der Volumenschallwellenresonator (102) und die Induktivität (104) innerhalb des Dichtungsrings befinden.

10. Schaltung nach Anspruch 8, wobei der Volumenschallwellenresonator (102) mit der Induktivität (104) in Reihe gekoppelt ist.

11. Schaltung nach Anspruch 10, die ferner umfasst:
den ersten E/A-Anschluss (800A) in der Metallschicht (802); und
den zweiten E/A-Anschluss (800B) in der Metallschicht (802);
wobei:
die Induktivität (104) beinhaltet:
einen ersten Anschluss, der mit dem ersten E/A-Anschluss (800A) gekoppelt ist; und
einen zweiten Anschluss;
wobei der Volumenschallwellenresonator (102) beinhaltet:
einen ersten Anschluss, der mit einem zweiten Anschluss der Induktivität (104) gekoppelt ist; und
einen zweiten Anschluss, der mit dem zweiten E/A-Anschluss (800B) gekoppelt ist.

12. Schaltung nach Anspruch 8, wobei der Volumenschallwellenresonator (102) mit der Induktivität (104) parallel gekoppelt ist.

13. Schaltung nach Anspruch 12, die ferner umfasst:
den ersten E/A-Anschluss (800A) in der Metallschicht (802); und
den zweiten E/A-Anschluss (800B) in der Metallschicht (802);
wobei:
die Induktivität (102) beinhaltet:
einen ersten Anschluss, der mit dem ersten E/A-Anschluss (800A) gekoppelt ist; und
einen zweiten Anschluss, der mit dem zweiten E/A-Anschluss (800B) gekoppelt ist.

## Revendications

1. Circuit comprenant :
un substrat semi-conducteur (800) ; et
un dispositif passif intégré (104) sur une surface du substrat semi-conducteur (800), le dispositif passif intégré (104) étant situé dans une couche métallique (802) d'une épaisseur d'au moins 30 micromètres sur le substrat semi-conducteur (800), où le dispositif passif intégré (104) est un inducteur, le circuit comprenant en outre :
un résonateur à ondes acoustiques de volume (102) sur le substrat semi-conducteur (800), couplé à l'inducteur (104),
une première borne d'E/S (800A) dans la couche métallique (802) ;
une deuxième borne d'E/S (800B) dans la couche métallique (802) ; et
un condensateur dans la couche métallique (802), où l'inducteur (104) comprend :
une première borne couplée à la première borne d'E/S (800A) ; et
une deuxième borne couplée à la deuxième borne d'E/S (800B) et à une borne du condensateur.

2. Circuit selon la revendication 1, comprenant en outre un anneau de scellement dans la couche métallique (802) ; où le résonateur à ondes acoustiques de volume (102) et l'inducteur (104) se situent à l'intérieur de l'anneau de scellement.

3. Circuit selon la revendication 1, dans lequel le résonateur à ondes acoustiques de volume (102) est couplé en série avec l'inducteur (104).

4. Circuit selon la revendication 3, comprenant en outre :
la première borne d'E/S (800A) dans la couche métallique (802) ; et
la deuxième borne d'E/S (800B) dans la couche métallique (802) ;
où :
l'inducteur (104) comprend :
une première borne couplée à la première borne d'E/S (800A) ; et
une deuxième borne ;
le résonateur à ondes acoustiques de volume (102) comprend :
une première borne couplée à la deuxième borne de l'inducteur (104) ; et
une deuxième borne couplée à la deuxième borne d'E/S (800B).

5. Circuit selon la revendication 1, dans lequel le résonateur à ondes acoustiques de volume (102) est couplé en parallèle avec l'inducteur (104).

6. Circuit selon la revendication 5, comprenant en outre :
la première borne d'E/S (800A) dans la couche métallique (802) ; et
la deuxième borne d'E/S (800B) dans la couche métallique (802) ; où :
l'inducteur (104) comprend :
une première borne couplée à la première borne d'E/S (800A) ; et
une deuxième borne couplée à la deuxième borne d'E/S (800B).

7. Circuit selon la revendication 1, dans lequel :
l'inducteur (104) est un premier inducteur ; et
le circuit comprend :
un deuxième inducteur dans la couche métallique (802) ; et
le deuxième inducteur comprend :
une première borne couplée à la première borne du premier inducteur (104) ; et
une deuxième borne couplée à la deuxième borne d'E/S (800B).

8. Circuit selon la revendication 1, comprenant :
un résonateur à ondes acoustiques de volume (102) sur le substrat semi-conducteur (800) ; et
la couche métallique (802) qui a une épaisseur d'au moins 30 micromètres sur une surface du substrat semi-conducteur (800) ;
la couche métallique (802) étant structurée pour former l'inducteur (104) couplé au résonateur à ondes acoustiques de volume (102).

9. Circuit selon la revendication 8, comprenant en outre un anneau de scellement dans la couche métallique (802) ; où le résonateur à ondes acoustiques de volume (102) et l'inducteur (104) se situent à l'intérieur de l'anneau de scellement.

10. Circuit selon la revendication 8, dans lequel le résonateur à ondes acoustiques de volume (102) est couplé en série avec l'inducteur (104).

11. Circuit selon la revendication 10, comprenant en outre :
la première borne d'E/S (800A) dans la couche métallique (802) ; et
la deuxième borne d'E/S (800B) dans la couche métallique (802) ; où :
l'inducteur (104) comprend :
une première borne couplée à la première borne d'E/S (800A) ; et
une deuxième borne ;
le résonateur à ondes acoustiques de volume (102) comprend :
une première borne couplée à la deuxième borne de l'inducteur (104) ; et
une deuxième borne couplée à la deuxième borne d'E/S (800B).

12. Circuit selon la revendication 8, dans lequel le résonateur à ondes acoustiques de volume (102) est couplé en parallèle avec l'inducteur (104).

13. Circuit selon la revendication 12, comprenant en outre :
la première borne d'E/S (800A) dans la couche métallique (802) ; et
la deuxième borne d'E/S (800B) dans la couche métallique (802) ; où :
l'inducteur (102) comprend :
une première borne couplée à la première borne d'E/S (800A) ; et
une deuxième borne couplée à la deuxième borne d'E/S (800B).
